**Europäisches Patentamt**

**European Patent Office**

**Office européen des brevets**

(19)

(11) Veröffentlichungsnummer: **0 143 262**
A1

# (12) EUROPÄISCHE PATENTANMELDUNG

(21) Anmeldenummer: **84111566.0**

(22) Anmeldetag: **27.09.84**

(51) Int. Cl.⁴: **H 01 L 23/40**

(30) Priorität: **29.09.83 DE 3335377**

(43) Veröffentlichungstag der Anmeldung: **05.06.85**
**Patentblatt 85/23**

(84) Benannte Vertragsstaaten: **AT BE CH DE FR GB IT LI NL SE**

(71) Anmelder: **Siemens Aktiengesellschaft, Berlin und München Wittelsbacherplatz 2, D-8000 München 2 (DE)**

(72) Erfinder: **Hermann, Adam, Dipl.-Ing., Massmannstrasse 2, D-8000 München 2 (DE)**

(54) **Einrichtung zum Festhalten eines Kühlkörpers auf einem integrierten Baustein.**

(57) Die Einrichtung besteht aus einer unter dem integrierten Baustein (2) anzuordnenden festen Isolierstoffplatte (4) mit einer mindestens der Anzahl, Größe und Anordnung der Anschlußstifte (3) des integrierten Bausteines (2) entsprechenden Anzahl von Löchern (5) sowie an zwei gegenüberliegenden Kanten (6) der Isolierstoffplatte (4) angeordneten Klemmhaken (7), die sich beim Aufsetzen des Kühlkörpers (1) auf den integrierten Baustein (2) an Rastkanten (8) des Kühlkörpers (1) festklemmen.

SIEMENS AKTIENGESELLSLCHAFT
BERLIN UND MÜNCHEN

0143262

Unser Zeichen

VPA **83** P **1760** E

Einrichtung zum Festhalten eines Kühlkörpers auf
einem integrierten Baustein

Die Erfindung bezieht sich auf eine Einrichtung zum
Festhalten eines Kühlkörpers auf einem integrierten
Baustein und insbesondere auf einem solchen Baustein,
bei dem die Anschlüsse auf der Unterseite des Bausteines bis weit an den Rand hin angeordnet sind.

Für das Befestigen von Kühlkörpern auf Einzelhalbleitern wird häufig entweder die Methode des Festschraubens
oder die des Festklemmens durch eine federnde Ausgestaltung des Kühlkörpers selbst angewendet. Diese Maßnahmen
eignen sich aber nicht für die Befestigung von Kühlkörpern auf integrierten Schaltkreisen, insbesondere solchen mit einer Vielzahl von auf der Unterseite angeordneten Anschlüssen, die in der Regel bis weit an den
Rand des Bausteines hin angeordnet sind. Deshalb ist es
auch schon bekannt geworden, die Kühlkörper unmittelbar
auf die Oberseite der integrierten Bausteine zu kleben.
Eine Schwierigkeit dieser Methode ist, daß der Kühlkörper
zumindest bis zur Aushärten des Klebers ruhig in der gewünschten Lage gehalten werden muß. Zur Befestigung
eines Kühlkörpers auf einem integrierten Baustein ist
es ferner bekannt geworden, diesen mit Hilfe eines Federbügels von oben her auf den integrierten Baustein
zu drücken. Die bekannten Federbügel bestehen aus Federstahlblech und bewirken damit die Gefahr eines Kurzschlusses der auf der Unterseite des Bausteines bis weit
an den Rand hin angeordneten Anschlüsse. Zur Vermeidung
dieser Gefahr sind deshalb zwischen dem Federbügel und

Kar 1 Stl / 26.09.83

0143262
83 P 1760 E

dem integrierten Baustein noch Isolierstoffteile angeordnet. Dies wiederum hat den Nachteil, daß außer dem
Federbügel noch Isolierstoffteile hergestellt und montiert werden müssen und daß der Federbügel dadurch seitlich zusätzlichen Platz einnimmt, was bei der hohen
Packungsdichte moderner elektronischer Anlagen äußerst
unerwünscht ist. Da die bekannten Federbügel zum Befestigen eines Kühlkörpers auf einem integrierten Baustein diesen von oben her auf den Baustein drücken, wird
auch in der Höhe zusätzlicher Raum durch den Federbügel
vergeudet und der Kühlkörper muß bei einer vorgegebenen
Einbauhöhe entsprechend niedriger gemacht werden, das zu
einer geringeren Kühlleistung führt.

Ein weiteres Problem beim Bestücken von Leiterplatten
mit solchen integrierten Bausteinen ist die Gefahr des
Kurzschlusses der Anschlüsse auf der Unterseite der
integrierten Bausteine durch das in der Regel angewendete Schwallöten. Es ist deshalb auch schon bekannt,
solche integrierte Bausteine auf der Unterseite mit
einer Abdeckfolie zu versehen, die die Anschlüsse des
Bausteines vor Lötspritzern schützt. Diese Folien sind
aber in der Regel empfindliche Teile und für eine
automatische Bestückung nicht sehr gut geeignet.

Der Erfindung lag daher die Aufgabe zugrunde, eine Einrichtung zum Festhalten eines Kühlkörpers zu schaffen,
die die Nachteile der oben genannten bekannten Einrichtungen vermeidet und außerdem beim Verlöten der Bausteine mit der Leiterplatte als Abstandshalter dient.

Erfindungsgemäß wird diese Aufgabe gelöst durch eine
unter dem integrierten Baustein anzuordnende feste
Isolierstoffplatte mit einer mindestens der Anzahl,
Größe und Anordnung der Anschlußstifte des integrier-

0143262

ten Bausteins entsprechenden Anzahl von Löchern sowie an zwei gegenüberliegenden Kanten der Isolierstoffplatte angeordneten federnde Rasthaken, die sich beim Aufsetzen des Kühlkörpers auf den integrierten Baustein an Rastkanten des Kühlkörpers festklemmen.

Weitere Merkmale der Erfindung ergeben sich aus den Unteransprüchen.

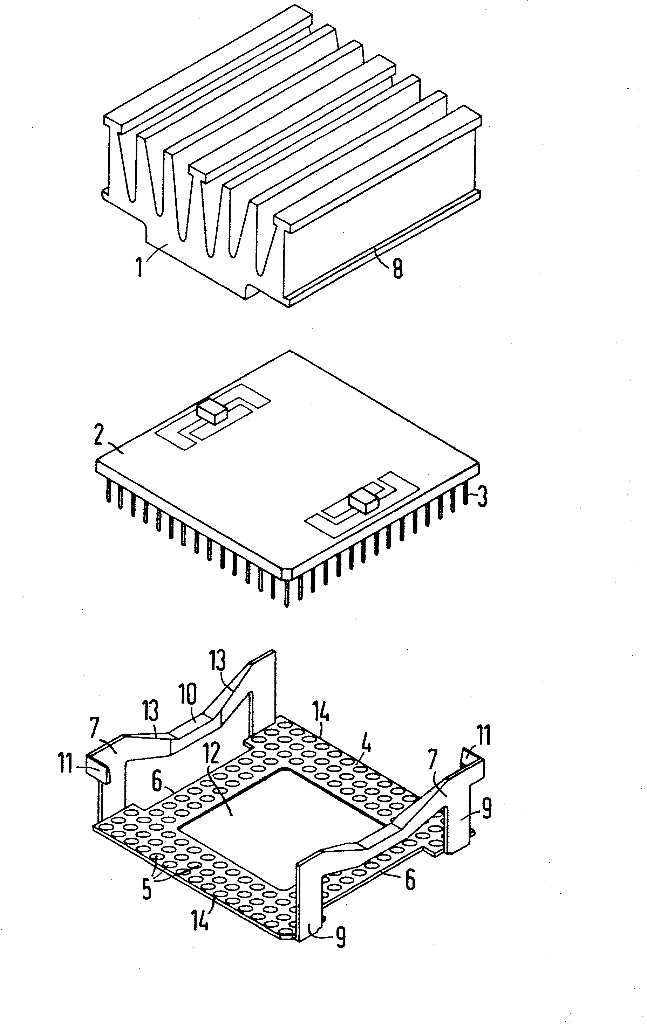

Im folgenden wird die Erfindung anhand eines in der Zeichnung dargestellten vorteilhaften Ausführungsbeispiels derselben näher erläutert.

Die Zeichnung zeigt in Explosionsdarstellung einen integrierten Baustein 2, bei dem die Anschlüsse 3 auf der Unterseite des Bausteines bis weit an den Rand hin angeordnet sind sowie einen Kühlkörper 1, der auf dem integrierten Baustein 2 festgehalten werden soll. Und zwar soll der Kühlkörper 1 entweder dauernd auf dem integrierten Baustein festgeklemmt oder, falls der Kühlkörper 1 auf dem integrierten Baustein 2 festgeklebt werden soll, bis zum Aushärten des Klebers ruhig in der gewünschten Lage gehalten werden.

Hierzu dient die erfindungsgemäße Einrichtung aus einer unter dem integrierten Baustein 2 anzuordnenden festen Isolierstoffplatte 4 mit einer mindestens der Anzahl, Größe und Anordnung der Anschlußstifte 3 des integrierten Bausteins 2 entsprechenden Anzahl von Löchern 5. An zwei gegenüberliegenden Kanten 6 der Isolierstoffplatte 4 sind federnde Rasthaken 7 angeordnet, die sich beim Aufsetzen des Kühlkörpers 1 auf den integrierten Baustein 2 an Rastkanten 8 des Kühlkörpers 1 festklemmen. Zu diesem Zweck können entweder an den beiden gegenüberliegenden Kanten 6 jeweils mehrere

0143262

schmale Klemmhaken oder ein durchgehender Klemmhaken 7 angeordnet werden, wie er in der Zeichnung dargestellt worden ist. Die Rasthaken 7 sind in etwa U-förmig ausgebildet und stehen mit ihren freien Schenkeln 9 senkrecht auf dem Rand 6 der Isolierstoffplatte 4. Bei der in der Zeichnung dargestellten besonders vorteilhaften Ausführungsform der erfindungsgemäßen Einrichtung ist der Mittelteil der U-förmigen Rasthaken 7 in Richtung auf die Isolierstoffplatte 4 zu V-förmig abgesenkt und nach innen gezogen. Dadurch ergeben sich im Mittelteil der U-förmigen Rasthaken 7 schräg nach innen und unten verlaufende Kanten 13, die ein leichtes Einführen der Rastkanten 8 des Kühlkörpers 1 ermöglichen. Dies ist besonders dann wichtig, wenn die erfindungsgemäße Einrichtung maschinell automatisch montiert werden soll.

Die beiden Rasthaken 7 an den beiden gegenüberliegenden Kanten 6 der Isolierstoffplatte 4 halten zwar den Kühlkörper 1 auf dem integrierten Baustein 2 fest, können dies aber nur nach oben hin und nach den beiden Seiten hin tun, auf denen die beiden Rasthaken 7 angeordnet sind. Damit sich der Kühlkörper nicht in Richtung der beiden anderen Kanten verschieben kann, sind gemäß einer anderen Weiterbildung der Erfindung Laschen 11 vorgesehen, die den Kühlkörper 1 auf dem integrierten Baustein in seiner richtigen Lage justieren. Solche Laschen 11 könnten jeweils paarweise, z.B. an den Kanten 14 der Isolierstoffplatte 4 senkrecht nach oben stehend angeordnet werden. Als besonders vorteilhaft hat es sich jedoch erwiesen, wechselseitig an je einem der Schenkel der U-förmigen Rasthaken 7 eine Justierlasche 11 anzuordnen, wie es in der Zeichnung dargestellt ist.

0143262

Eine andere Weiterbildung bezieht sich auf die Isolierstoffplatte 4 selbst, und zwar die Unterseite der Isolierstoffplatte, wo im nicht von Öffnungen für die Anschlußstifte des integrierten Bausteins belegten Bereich 12 nebeneinander angeordnete rippenartige Erhöhungen vorgesehen sind (nicht dargestellt). Diese rippenartigen Erhöhungen bilden zwischen sich Kanäle, durch die die beim Schwallöten entstehenden Dämpfe entweichen können. Es kann aber auch zweckmäßig sein, in diesem Bereich 12 der Isolierstoffplatte 4 eine Vertiefung oder einen Durchbruch vorzusehen, wie es z.B. in der Zeichnung angedeutet ist.

Patentansprüche

1. Einrichtung zum Festhalten eines Kühlkörpers auf einem integrierten Baustein, g e k e n n z e i c h n e t durch eine unter dem integrierten Baustin (2) anzuordnende feste Isolierstoffplatte (4) mit einer vorzugsweise der Anzahl, Größe und Anordnung der Anschlußstifte (3) des integrierten Bausteines (2) ensprechenden Anzahl von Löchern (5) sowie an zwei gegenüberliegenden Kanten (6) der Isolierstoffplatte (4) angeordneten federnden Rasthaken (7), die sich beim Aufsetzen des Kühlkörpers (1) auf den integrierten Baustein (2) an Rastkanten (8) des Kühlkörpers (1) festklemmen.

2. Einrichtung nach Anspruch 1, g e k e n n z e i c h - n e t durch jeweils mehrere an den beiden gegenüberliegenden Kanten angeordnete federnde Rasthaken.

3. Einrichtung nach Anspruch 1, g e k e n n z e i c h - n e t durch je einen durchgehenden federnden Rasthaken (7) an jeder der beiden Kanten (6).

4. Einrichtung nach Anspruch 3, d a d u r c h  g e k e n n z e i c h n e t, daß die Rasthaken (7) in etwa U-förmig ausgebildet sind und mit ihren freien Schenkeln (9) senkrecht auf dem Rand (6) der Isolierstoffplatte (4) stehen.

5. Einrichtung nach Anspruch 4, d a d u r c h  g e k e n n z e i c h n e t, daß der Mittelteil der U-förmigen Rasthaken (7) in Richtung auf die Isolierstoffplatte (4) V-förmig abgesenkt und nach innen gezogen ist.

0143262

6. Einrichtung nach einem der Ansprüche 1 bis 5, g e k e n n z e i c h n e t durch Laschen (11) zum Justieren des Kühlkörpers (1) auf dem integrierten Baustein (2).

7. Einrichtung nach Anspruch 6, g e k e n n z e i c h - n e t durch je zwei an den Kanten (14) der Isolierstoffplatte senkrecht nach oben stehend angeordnete Justierlaschen.

8. Einrichtung nach Anspruch 6, g e k e n n z e i c h - n e t durch wechselseitig an je einem der Schenkel jedes U-förmigen Rasthakens (7) angeordnete Justierlaschen (11).

9. Einrichtung nach einem der Ansprüche 1 bis 8, g e - k e n n z e i c h n e t durch auf der Unterseite der Isolierstoffplatte (4) im nicht von Öffnungen für die Anschlußstifte des integrierten Bausteines belegten Bereich (12) nebeneinander angeordnete rippenartige Erhöhungen.

10. Einrichtung nach einem der Ansprüche 1 bis 8, g e k e n n z e i c h n e t durch eine Vertiefung oder einen Durchbruch (12) in dem nicht mit Öffnungen (5) für die Anschlußstifte (3) des integrierten Bausteines (2) belegen Bereich der Isolierstoffplatte (4).

0143262

**Europäisches Patentamt**

**EUROPÄISCHER RECHERCHENBERICHT**

0143262

Nummer der Anmeldung

EP 84 11 1566

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 293 175 (J.M. CUTSHAW) * Figuren 4,5,15; Spalte 9, Zeilen 34-42 * | 1 | H 01 L 23/40 |
| Y | DE-A-2 032 402 (REDPOINT) * Figur 5; Seiten 6,7 * | 1-4 | |
| A | IBM TECHNICAL DISCLOSURE BULLETIN, Band 23, Nr. 11, April 1981, Seite 4850, New York, US; R.F. KILBURN et al.: "Means of attaching a heat sink to a module" | 1 | |
| | | | **RECHERCHIERTE SACHGEBIETE (Int. Cl.4)** |
| | | | H 01 L |

Der vorliegende Recherchenbericht wurde für alle Patentansprüche erstellt.

| Recherchenort DEN HAAG | Abschlußdatum der Recherche 13-12-1984 | Prüfer DE RAEVE R.A.L. |
|---|---|---|